# FASCICULE DE BREVET EUROPEEN

(11) **EP 2 533 619 B1**
(45) Date de publication et mention de la délivrance du brevet: **20.12.2017**
(21) Numéro de dépôt: 12170802.8
(22) Date de dépôt: 05.06.2012
(51) Int. Cl.: H05K 5/06, H02M 7/00

(54) **Dispositif de conversion d'énergie comprenant une enceinte étanche de logement d'un module de puissance et au moins un orifice de passage d'une liaison à travers un tronçon d'extrémité de l'enceinte, et procédé de fabrication d'un tel dispositif**
Vorrichtung zur Umwandlung von Energie, die einen dichten Behälter zur Aufnahme des Leistungsmoduls und mindestens eine Öffnung zur Durchführung einer Verbindungsleitung durch das Endstück des Behälters umfasst und Herstellungsverfahren einer solchen Vorrichtung
Power conversion device comprising a sealed enclosure for housing a power module and at least one opening for passing a link through an end portion of the enclosure, and method for manufacturing such a device

(30) Priorité: 07.06.2011 FR 1154939
(43) Date de publication de la demande: 12.12.2012
(73) Titulaire: GE Energy Power Conversion Technology Limited, Rugby Warwickshire CV21 1BU (GB)
(72) Inventeur: Baerd, Henri, 77430 Champagne sur Seine (FR); Renaud, Guillaume, 91300 Massy (FR)
(74) Mandataire: Serjeants LLP

(56) Documents cités:
- EP-A1- 1 310 759
- EP-A1- 2 234 468
- FR-A1- 2 711 300
- US-A1- 2010 208 446

## Description

La présente invention concerne un dispositif de conversion d'énergie électrique pour un système d'entraînement électrique de station sous-marine de compression et de pompage, selon la revendication 1. La présente invention s'applique notamment à un dispositif de conversion d'énergie électrique propre à être immergé à une profondeur supérieure à 50m.

L'invention concerne également un procédé de fabrication d'un tel dispositif de conversion d'énergie électrique.

On connaît un dispositif de conversion d'énergie électrique du type précité. L'enceinte étanche comporte trois tronçons successifs suivant la direction longitudinale, à savoir un tronçon intermédiaire et deux tronçons d'extrémité disposés de part et d'autre du tronçon intermédiaire selon la direction longitudinale. Le tronçon intermédiaire comporte une paroi en forme d'un cylindre, et présente une ouverture d'extrémité à chaque extrémité du cylindre. L'ensemble des orifices de passage d'une liaison filaire du module de puissance avec un appareil extérieur à l'enceinte étanche est ménagé à travers la paroi cylindrique du tronçon intermédiaire.

Pendant la fabrication du dispositif de conversion d'énergie électrique, lors du test du fonctionnement du module de puissance, le module de puissance est agencé à l'intérieur du tronçon intermédiaire, et est connecté aux équipements de test par l'intermédiaire de liaisons filaires passant à travers les divers orifices de passage ménagés dans la paroi cylindrique du tronçon intermédiaire. Le module électrique de puissance comporte plusieurs équipements électriques de puissance agencés le long de la direction longitudinale à l'intérieur du tronçon intermédiaire. Le document de priorité GB19960020252 du document EP 1 310 759 A1 décrit un dispositif de conversion d'énergie électrique pour un système d'entraînement électrique de station sous-marine de compression et de pompage selon le préambule de la revendication 1. EP 2 234 468 A1 décrit un dispositif de conversion d'énergie électrique comprenant un module électrique de puissance et une enceinte étanche de logement du module de puissance, l'enceinte étanche s'étendant selon une direction longitudinale.

FR 2 711 300 A1 décrit un boîtier électronique immergeable comprenant un module électrique et une enceinte étanche de logement du module électrique. Le boîtier immergeable comprend un orifice de passage d'une liaison filaire, l'orifice de passage étant ménagé à travers la paroi d'un tronçon d'extrémité de l'enceinte.

Toutefois, en cas de détection de panne d'un équipement au cours du test, l'accès à cet équipement peut être particulièrement difficile à travers l'une ou l'autre des ouvertures d'extrémité du tronçon intermédiaire, en vue de diagnostiquer le dysfonctionnement voire de remplacer l'équipement.

Le but de l'invention est donc de proposer un dispositif de conversion d'énergie électrique offrant une meilleure accessibilité au module de puissance, notamment lors du test du fonctionnement du module de puissance.

A cet effet, l'invention a pour objet un dispositif de conversion d'énergie électrique selon la revendication 1.

Suivant d'autres modes de réalisation, le dispositif de conversion comprend une ou plusieurs des caractéristiques suivantes, prises isolément ou suivant toutes les combinaisons techniquement possibles :
- tous les orifices de passage sont ménagés à travers la paroi du tronçon d'extrémité,
- l'enceinte étanche comporte uniquement deux tronçons distincts, le tronçon d'extrémité présentant une longueur inférieure à celle de l'autre tronçon selon la direction longitudinale,
- le tronçon d'extrémité présente une longueur inférieure à 0,3 fois la longueur de l'enceinte selon la direction longitudinale, de préférence inférieure à 0,2 fois de la longueur de l'enceinte, de préférence encore inférieure à 0,1 fois la longueur de l'enceinte,
- le tronçon d'extrémité comporte un dôme, et l'orifice de passage ou la majorité des orifices de passage est agencé sur le dôme du tronçon d'extrémité,
- le ou chaque tronçon distinct du tronçon d'extrémité et le module de puissance comportent chacun des moyens complémentaires de coulissement le long de la direction longitudinale ; et
- l'épaisseur de la paroi du ou de chaque tronçon distinct du tronçon d'extrémité est inférieure à celle de la paroi du tronçon d'extrémité, de préférence inférieure d'au moins 10 % à celle de la paroi du tronçon d'extrémité, de préférence encore inférieure d'au moins 30 % à celle de la paroi du tronçon d'extrémité.

L'invention a également pour objet un procédé de fabrication d'un dispositif de conversion d'énergie électrique pour un système d'entraînement électrique de station sous-marine de compression et de pompage, selon la revendication 8. Suivant un autre mode de réalisation, le procédé de fabrication comprend les caractéristiques suivantes :
- chaque orifice de passage est ménagé à travers la paroi du tronçon d'extrémité, et lors de l'étape de fermeture, chaque liaison filaire est maintenue en position à l'intérieur du tronçon d'extrémité et dans l'orifice de passage correspondant.

Ces caractéristiques et avantages de l'invention apparaîtront à la lecture de la description qui va suivre, donnée uniquement à titre d'exemple, et faite en référence aux dessins annexés, sur lesquels :
- la figure 1 est une vue de face d'un dispositif de conversion d'énergie électrique selon l'invention, le dispositif comprenant un module électrique de puissance et une enceinte étanche de logement du module de puissance, l'enceinte comportant deux tronçons successifs suivant une direction longitudinale,
- la figure 2 est une vue en perspective d'un tronçon d'extrémité de l'enceinte de la figure 1,
- la figure 3 est une vue en perspective de l'autre tronçon de l'enceinte de la figure 1, et
- la figure 4 est une vue en coupe suivant le plan IV de la figure 1.

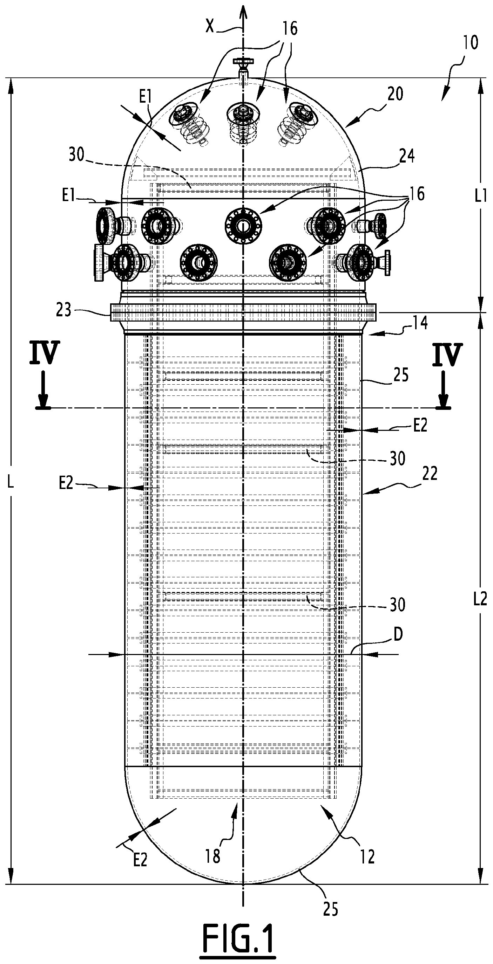

Sur la figure 1, un dispositif 10 de conversion d'énergie électrique comprend un module électrique de puissance 12, représenté partiellement en traits pointillés, et une enceinte étanche 14 de logement du module de puissance.

Le dispositif de conversion 10 est destiné à alimenter un système, non représenté, d'entraînement électrique de station sous-marine de compression et de pompage.

Le dispositif de conversion 10 est destiné à être immergé à une profondeur supérieure à 50 mètres, par exemple comprise entre 1000 mètres et 3000 mètres. Le dispositif de conversion 10 résiste alors à une pression extérieure supérieure à 6 bars, par exemple comprise entre 100 bars et 300 bars.

Le dispositif de conversion 10 comprend une pluralité d'orifices 16 de passage d'une liaison filaire du module de puissance 12 avec un appareil, non représenté, extérieur au dispositif de conversion, l'orifice de passage 16 étant ménagé à travers l'enceinte 14.

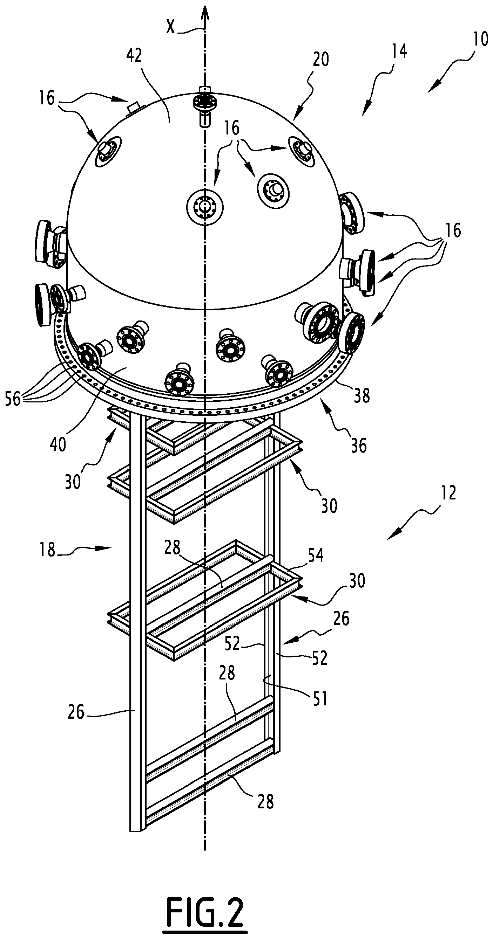

Le module électrique de puissance 12 comprend une ossature mécanique 18, représentée en pointillés sur la figure 1 et visible sur la figure 2, et des équipements électriques de puissance, non représentés, fixés à l'ossature mécanique 18.

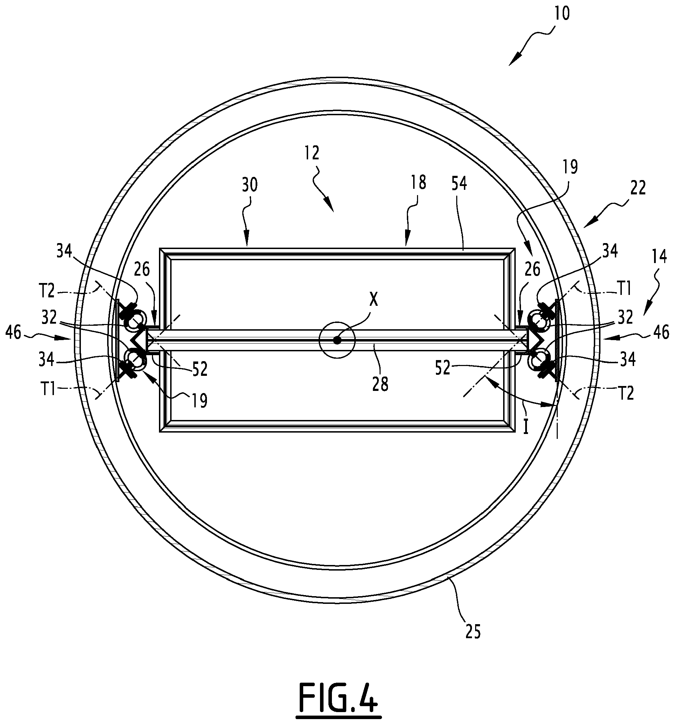

Le module de puissance 12 comprend des moyens 19 d'appui contre l'enceinte, visibles sur la figure 4.

Le module électrique de puissance 12 présente une puissance électrique élevée, telle qu'une puissance électrique de valeur supérieure à 100 kW, de préférence supérieure à 1 MW.

L'enceinte étanche 14 s'étend selon une direction longitudinale X. L'enceinte étanche 14 est partiellement en forme d'un cylindre et présente un diamètre D de valeur comprise entre un et trois mètres, comme représenté sur la figure 1. L'enceinte étanche 14 présente une longueur L selon la direction longitudinale X. La longueur L est, par exemple, de l'ordre de dix mètres.

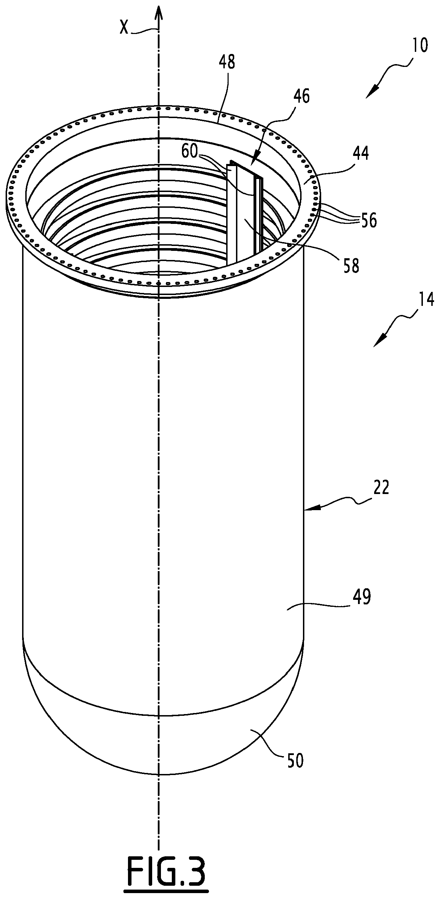

L'enceinte étanche 14 comporte un premier tronçon 20 et un deuxième tronçon 22 successifs suivant la direction longitudinale X, et mobiles entre une position de fermeture de l'enceinte 14 dans laquelle les tronçons 20, 22 sont fixés les uns aux autres (figure 1) et une position d'ouverture de l'enceinte 14 dans laquelle les tronçons 20, 22 sont à l'écart les uns des autres (figures 2 et 3).

L'enceinte étanche 14 comporte un joint d'étanchéité 23 disposé entre les tronçons 20, 22. Chaque tronçon 20, 22 comporte une paroi 24, 25 respective.

Dans l'exemple de réalisation de la figure 1, l'enceinte étanche 14 comporte uniquement deux tronçons distincts, à savoir le premier tronçon 20 et le deuxième tronçon 22. Le premier tronçon 20 est également appelé tronçon d'extrémité, et le deuxième tronçon 22 est également appelé tronçon principal. Chaque orifice de passage 16 est ménagé à travers la paroi d'un tronçon correspondant. Une majorité des orifices de passage 16 est ménagée à travers la paroi 24 de l'unique tronçon d'extrémité 20. De préférence encore, tous les orifices de passage 16 sont ménagés à travers la paroi 24 du tronçon d'extrémité 20, comme représenté sur la figure 1.

La liaison filaire est, par exemple, une liaison électrique. Chaque liaison filaire électrique comporte, par exemple, un ensemble passe-tige monté au travers de l'orifice de passage 16 correspondant. L'ensemble passe-tige est connu en soi, et comprend une tige électriquement conductrice, une gaine électriquement isolante et solidaire de la tige, et une bague montée au travers de l'orifice de passage 16. La tige équipée de la gaine est disposée dans un passage intérieur de la bague.

En complément ou en variante, la liaison filaire est une liaison optique. Chaque liaison filaire optique comporte, par exemple, une fibre optique ou un ensemble de fibres optiques.

En complément ou en variante, la liaison filaire est une liaison hydraulique. Chaque liaison filaire hydraulique comporte, par exemple, un tube creux à l'intérieur duquel un fluide est propre à circuler.

L'ossature mécanique 18, visible sur la figure 2, comprend deux poutres 26 sensiblement longitudinales et au moins deux traverses 28, chaque traverse 28 reliant mécaniquement les deux poutres longitudinales 26. Les poutres longitudinales 26 et les traverses 28 forment un cadre disposé dans un plan médian de l'enceinte étanche 14.

En complément, l'ossature mécanique 18 comprend au moins un plateau transversal 30 agencé perpendiculairement aux poutres longitudinales 26. Dans l'exemple de réalisation de la figure 1, l'ossature mécanique 18 comprend cinq plateaux transversaux 30.

L'ossature mécanique 18 du module de puissance est solidaire du premier tronçon 20. L'ossature mécanique 18 est, par exemple, reliée à l'intérieur du premier tronçon 20 par l'intermédiaire d'éléments de suspension non représentés.

L'ossature mécanique 18 est, par exemple, réalisée en acier, en acier inoxydable, en aluminium, ou encore en matériau composite, tel que le carbone ou la fibre de verre.

Les moyens d'appui 19 sont solidaires d'une poutre longitudinale 26 correspondante et sont répartis successivement le long de ladite poutre longitudinale 26 selon la direction longitudinale X.

Dans l'exemple de réalisation de la figure 4, les moyens d'appui 19 comportent une pluralité de paires de ressorts 32 équipés chacun d'une platine d'appui 34.

Le premier tronçon 20, visible sur la figure 2, est fermé à une extrémité longitudinale et comporte une ouverture 36 à son autre extrémité longitudinale. Le premier tronçon 20 comporte une première bride 38 de fixation avec le deuxième tronçon, une partie cylindrique 40 solidaire de la première bride et un dôme 42 fixé à la partie cylindrique du côté opposé à la première bride.

Le premier tronçon 20 présente une première longueur L1 selon la direction longitudinale X. La première longueur L1 est inférieure à la moitié de la longueur L de l'enceinte selon la direction longitudinale X.

Dans l'exemple de réalisation de la figure 1, la première longueur L1 est inférieure à 0,3 fois la longueur L de l'enceinte. En variante, la première longueur L1 est inférieure à 0,2 fois la longueur L de l'enceinte, de préférence encore inférieure à 0,1 fois la longueur L de l'enceinte.

Le premier tronçon 20 est, par exemple, réalisé en acier, en titane, en une composition hybride d'acier et de béton, ou encore en une composition hybride d'acier et d'un matériau composite, tel que le carbone ou la fibre de verre.

Le deuxième tronçon 22, visible sur la figure 3, comporte une deuxième bride 44 de fixation au premier tronçon et deux glissières 46 fixées à l'intérieur du deuxième tronçon de manière diamétralement opposée par rapport à un axe médian du deuxième tronçon, l'axe médian étant parallèle à la direction longitudinale X.

Le deuxième tronçon 22 comporte une ouverture 48 agencée en une de ses extrémités, et est fermée en l'autre de ses extrémités.

Dans l'exemple de réalisation de la figure 3, le deuxième tronçon 22 comporte une portion cylindrique 49 solidaire de la deuxième bride de fixation et un dôme 50 fixé à la portion cylindrique du côté opposé à la bride de fixation.

Le deuxième tronçon 22 présente une deuxième longueur L2 selon la direction longitudinale X. La deuxième longueur L2 est strictement supérieure à la première longueur L1.

Dans l'exemple de réalisation de la figure 1, la deuxième longueur L2 est supérieure à 0,7 fois la longueur L de l'enceinte selon la direction longitudinale X. En variante, la deuxième longueur L2 est supérieure à 0,8 fois la longueur L de l'enceinte, de préférence encore supérieure à 0,9 fois la longueur L de l'enceinte.

Le deuxième tronçon 22 est, par exemple, réalisé en acier, en titane, en une composition hybride d'acier et de béton, ou encore en une composition hybride d'acier et d'un matériau composite, tel que le carbone ou la fibre de verre.

Le joint d'étanchéité 23 est disposé entre les brides de fixation 38, 44 respectives des premier et deuxième tronçons 20, 22. Le joint d'étanchéité 23 est, par exemple, un joint plat.

La paroi 24 du premier tronçon 20 présente une première épaisseur E1 selon une épaisseur radiale.

La paroi 25 du deuxième tronçon 22 présente une deuxième épaisseur E2 selon une direction radiale. La deuxième épaisseur E2 est inférieure à la première épaisseur E1. La deuxième épaisseur E2 est de préférence inférieure d'au moins 10 % à la première épaisseur E1. Dans l'exemple de réalisation de la figure 1, la deuxième épaisseur E2 est inférieure d'au moins 30% à la première épaisseur E1. Autrement dit, la deuxième épaisseur E2 est inférieure à 0,7 fois la première épaisseur E1.

Chaque poutre longitudinale 26 présente une section en forme de U, et comporte une âme longitudinale 51 et deux ailes 52 fixées chacune à un bord longitudinal de l'âme 51.

Les traverses 28 présentent une section en forme de H. Les extrémités des traverses 28 sont chacune insérées entre les deux ailes 52 de la poutre correspondante.

Chaque plateau transversal 30, visible sur la figure 2, comporte un cadre 54 fixé aux poutres longitudinales.

En complément, chaque plateau transversal 30 comporte la traverse 28 solidaire du cadre, la traverse 28 étant fixée en chacune de ses extrémités à une poutre longitudinale 26 correspondante.

Le premier ressort 32 de la paire de ressorts présente une première direction de travail T1, et le deuxième ressort 32 de la paire présente une deuxième direction de travail T2, la direction de travail T1, T2 de chaque ressort 32 étant la direction selon laquelle la force du ressort est supérieure à la force du ressort selon les autres directions. La première direction de travail T1 du premier ressort est perpendiculaire à la deuxième direction de travail T2 du deuxième ressort.

Chaque ressort 32 est fixé entre la poutre longitudinale 26 et la platine d'appui 34 correspondantes.

Chaque platine d'appui 34 est propre à glisser le long de la glissière 46 correspondante selon la direction longitudinale X, et les moyens d'appui 19 sont alors des moyens d'appui glissant.

La première bride de fixation 38, visible sur la figure 2, est fixée à la deuxième bride de fixation 44 en position de fermeture de l'enceinte. Dans l'exemple de réalisation de la figure 2, la première bride de fixation 38 comporte une pluralité de trous traversants longitudinaux 56 destinés à recevoir des moyens de fixation, non représentés, de la première bride 38 à la deuxième bride 44.

La partie cylindrique 40 du premier tronçon comporte la majorité des orifices de passage 16. Dans l'exemple de réalisation de la figure 2, la partie cylindrique 40 du premier tronçon comporte tous les orifices de passage 16.

En variante, le dôme 42 comporte la majorité des orifices de passage 16. Le dôme 42 comporte tous les orifices de passage 16.

Le dôme 42 est, par exemple, en forme d'une demi-sphère. En variante, le dôme 42 est en forme d'un demi-ellipsoïde.

La deuxième bride de fixation 44, visible sur la figure 3, est fixée à la première bride en position de fermeture de l'enceinte, et comporte une pluralité de trous traversants longitudinaux 56 destinés à recevoir les moyens de fixation, non représentés, de la première bride 38 avec la deuxième bride 44.

Chaque glissière 46, visible sur la figure 3, comporte une âme 58 et deux plans inclinés 60, l'âme 58 et les plans inclinés 60 s'étendant principalement selon la direction longitudinale X.

Les glissières 46 forment avec les moyens d'appui 19 des moyens complémentaires de coulissement le long de la direction longitudinale X.

Le dôme 50 est, par exemple, en forme d'une demi-sphère. En variante, le dôme 50 est en forme d'un demi-ellipsoïde.

Les plans inclinés 60 forment avec l'âme 58 un angle d'inclinaison I, visible sur la figure 4, sensiblement égal à 45 degrés. Les plans inclinés 60 d'une même glissière sont orientés de telle sorte qu'ils sont perpendiculaires l'un à l'autre, et sont propres à coopérer avec les platines d'appui 34 fixées à une paire de ressorts 32 respective.

Le procédé de fabrication du dispositif de conversion selon l'invention comprend le test du fonctionnement du module de puissance 12 en position d'ouverture de l'enceinte. Au cours du test, le module de puissance 12 est relié via une pluralité de liaisons filaires, non représentées, à des équipements de tests, non représentés, disposés à l'extérieur du dispositif de conversion 10. Les liaisons filaires passent à travers les orifices de passage 16, et le deuxième tronçon 22 est disposé à l'écart du premier tronçon 20 afin de laisser un accès important aux équipements électriques de puissance du module de puissance 12.

A l'issue du test du fonctionnement du module de puissance, l'enceinte étanche 14 est fermée en fixant le deuxième tronçon 22 au premier tronçon 20 et en maintenant en position les différentes liaisons filaires.

Plus précisément, le deuxième tronçon 22 est coulissé le long du module de puissance 12 selon la direction longitudinale X à l'aide des moyens complémentaires de coulissement 19, 46 jusqu'à ce que la deuxième bride de fixation 44 du deuxième tronçon vienne en contact avec la première bride de fixation 38 du premier tronçon. Des moyens de fixation, non représentés, sont alors reçus à travers les trous traversants 56 respectifs des première et deuxième brides de fixation 38, 44 afin de fixer les deux tronçons 20, 22 entre eux.

Lors de l'étape de fermeture, chaque liaison filaire est maintenue en position à l'intérieur du premier tronçon 20 et dans l'orifice de passage 16 correspondant.

Le dispositif de conversion 10 selon l'invention avec une pluralité d'orifices de passage 16 ménagés à travers la paroi du tronçon d'extrémité 20 permet d'écarter plus facilement le tronçon principal 22 du tronçon d'extrémité 20 lors de l'ouverture de l'enceinte, ce qui permet de faciliter l'accès au module électrique de puissance 12, notamment à ses équipements électriques de puissance.

Lorsque tous les orifices de passage 16 sont ménagés à travers la paroi 24 du tronçon d'extrémité 20, l'ouverture de l'enceinte étanche 14 est davantage facilitée, puisqu'il suffit de faire coulisser le tronçon principal 22 à l'écart du tronçon d'extrémité selon la direction longitudinale X, sans nécessiter la déconnexion d'une liaison filaire. En effet, toutes les liaisons filaires passent dans les orifices de passage 16 qui sont tous agencés dans l'autre tronçon de l'enceinte, c'est-à-dire dans le tronçon d'extrémité 20.

Les moyens complémentaires de coulissement 19, 46 permettent de guider « en aveugle » les poutres longitudinales 26 du module de puissance à l'intérieur du tronçon principal 22, ce qui simplifie par ailleurs la fermeture de l'enceinte étanche 14.

Le dispositif de conversion 10 selon l'invention permet également de réduire les risques de panne, puisqu'à l'issue d'un test positif de fonctionnement du module de puissance 12, l'enceinte étanche 14 est refermée sans avoir besoin de déconnecter les liaisons filaires correspondantes. Autrement dit, la configuration électrique du module de puissance 12 dans l'enceinte étanche après la fermeture de celle-ci est identique à la configuration électrique validée précédemment lors de l'étape de test.

En cas de test négatif conduisant à la détection d'une panne, le diagnostic du dysfonctionnement est facilité, puisque les équipements électriques de puissance du module de puissance 12 sont aisément accessibles lorsque le tronçon principal 22 est à l'écart du tronçon d'extrémité 20, comme représenté sur la figure 2.

En outre, un seul joint d'étanchéité 23 est nécessaire entre les deux tronçons 20, 22, ce qui permet d'améliorer l'étanchéité de l'enceinte 14 du dispositif de conversion selon l'invention.

L'homme du métier comprendra également que la maintenance du dispositif de conversion selon l'invention est plus facile, étant donné que l'ouverture de l'enceinte étanche 14 permet d'accéder directement aux équipements électriques de puissance du module de puissance 12 en cas de détection d'un dysfonctionnement du dispositif de conversion.

On conçoit ainsi que le dispositif de conversion d'énergie électrique permet d'offrir une meilleure accessibilité au module de puissance, notamment lors du test du fonctionnement du module de puissance.

## Revendications

1. Dispositif (10) de conversion d'énergie électrique pour un système d'entraînement électrique de station sous-marine de compression et de pompage, du type comprenant :
- un module électrique de puissance (12),
- une enceinte étanche (14) de logement du module de puissance (12), l'enceinte étanche (14) s'étendant selon une direction longitudinale (X), et comportant au moins deux tronçons (20, 22) successifs suivant la direction longitudinale (X), mobiles entre une position de fermeture de l'enceinte (14) dans laquelle les tronçons (20, 22) sont fixés les uns aux autres et une position d'ouverture de l'enceinte (14) dans laquelle les tronçons (20, 22) sont à l'écart les uns des autres, chaque tronçon (20, 22) comportant une paroi (24, 25),
**caractérisé en ce que** le dispositif (10) comprend en outre une pluralité d'orifices (16) de passage d'une liaison filaire du module de puissance (12) avec un appareil extérieur à l'enceinte étanche (14), chaque orifice de passage (16) étant ménagé à travers la paroi d'un tronçon correspondant, une majorité des orifices de passage (16) étant ménagée à travers la paroi (24) d'un unique tronçon d'extrémité (20) parmi la pluralité de tronçons (20, 22), le tronçon d'extrémité (20) présentant une longueur (L1) inférieure à la moitié de la longueur (L) de l'enceinte selon la direction longitudinale (X).

2. Dispositif de conversion (10) selon la revendication 1, dans lequel tous les orifices de passage (16) sont ménagés à travers la paroi du tronçon d'extrémité (20).

3. Dispositif de conversion (10) selon l'une quelconque des revendications précédentes, dans lequel l'enceinte étanche (14) comporte uniquement deux tronçons distincts (20, 22), le tronçon d'extrémité (20) présentant une longueur (L1) inférieure à celle (L2) de l'autre tronçon (22) selon la direction longitudinale (X).

4. Dispositif de conversion (10) selon l'une quelconque des revendications précédentes, dans lequel le tronçon d'extrémité (20) présente une longueur (L1) inférieure à 0,3 fois la longueur (L) de l'enceinte selon la direction longitudinale (X), de préférence inférieure à 0,2 fois de la longueur (L) de l'enceinte, de préférence encore inférieure à 0,1 fois la longueur (L) de l'enceinte.

5. Dispositif de conversion (10) selon l'une quelconque des revendications précédentes, dans lequel le tronçon d'extrémité (20) comporte un dôme (42), et l'orifice de passage ou la majorité des orifices de passage est agencé sur le dôme (42) du tronçon d'extrémité (20).

6. Dispositif de conversion (10) selon l'une quelconque des revendications précédentes, dans lequel le ou chaque tronçon (22) distinct du tronçon d'extrémité (20) et le module de puissance (12) comportent chacun des moyens complémentaires (19, 46) de coulissement le long de la direction longitudinale (X).

7. Dispositif de conversion (10) selon l'une quelconque des revendications précédentes, dans lequel l'épaisseur (E2) de la paroi du ou de chaque tronçon (22) distinct du tronçon d'extrémité (20) est inférieure à celle (E1) de la paroi du tronçon d'extrémité (20), de préférence inférieure d'au moins 10 % à celle (E1) de la paroi du tronçon d'extrémité (20), de préférence encore inférieure d'au moins 30 % à celle (E1) de la paroi du tronçon d'extrémité (20).

8. Procédé de fabrication d'un dispositif (10) de conversion d'énergie électrique pour un système d'entraînement électrique de station sous-marine de compression et de pompage, le dispositif (10) comprenant un module électrique de puissance (12), une enceinte étanche (14) de logement du module de puissance (12), l'enceinte étanche (14) s'étendant selon une direction longitudinale (X), et comportant au moins deux tronçons successifs (20, 22) suivant la direction longitudinale, mobiles entre une position de fermeture de l'enceinte (14) dans laquelle les tronçons (20, 22) sont fixés les uns aux autres et une position d'ouverture de l'enceinte (14) dans laquelle les tronçons (20, 22) sont à l'écart les uns des autres, chaque tronçon (20, 22) comportant une paroi (24, 25), et une pluralité d'orifices (16) de passage d'une liaison filaire du module de puissance (12) avec un appareil extérieur au dispositif de conversion (10), chaque orifice de passage (16) étant ménagé à travers la paroi d'un tronçon correspondant,
le procédé comprenant les étapes suivantes:
- le test du fonctionnement du module de puissance (12) en position d'ouverture de l'enceinte (14), au cours duquel le module de puissance (12) est relié via la ou chaque liaison filaire à l'appareil extérieur au dispositif de conversion (10), et
- la fermeture de l'enceinte étanche (14) en fixant les tronçons (20, 22) les uns aux autres,
le procédé étant **caractérisé en ce qu'**une pluralité de liaisons filaires passe à travers la pluralité d'orifices de passage (16), une majorité des orifices de passage (16) étant ménagée à travers la paroi d'un tronçon d'extrémité (20) parmi la pluralité de tronçons, le tronçon d'extrémité (20) présentant une longueur (L1) inférieure à la moitié de la longueur (L) de l'enceinte selon la direction longitudinale (X), et **en ce que** les liaisons filaires sont maintenues en position lors de l'étape de fermeture.

9. Procédé selon la revendication 8, dans lequel chaque orifice de passage (16) est ménagé à travers la paroi du tronçon d'extrémité (20), et dans lequel lors de l'étape de fermeture, chaque liaison filaire est maintenue en position à l'intérieur du tronçon d'extrémité (20) et dans l'orifice de passage (16) correspondant.

## Patentansprüche

1. Vorrichtung (10) zur Umwandlung elektrischer Energie für ein elektrisches Antriebssystem einer Unterwasserkompressions- und -pumpstation der Bauart, die aufweist:
- ein elektrisches Leistungsmodul (12),
- ein dichtes Gehäuse (14) zur Aufnahme des Leistungsmoduls (12), wobei sich das dichte Gehäuse (14) entlang einer Längsrichtung (X) erstreckt und wenigstens zwei aufeinanderfolgende Abschnitte (20, 22) entlang der Längsrichtung (X) aufweist, die zwischen einer geschlossenen Stellung des Gehäuses (14), in der die Abschnitte (20, 22) aneinander fixiert sind, und einer offenen Stellung des Gehäuses (14) bewegbar sind, in der die Abschnitte (20, 22) im Abstand zueinander angeordnet sind, wobei jeder Abschnitt (20, 22) eine Wand (24, 25) aufweist,
**dadurch gekennzeichnet, dass** die Vorrichtung (10) ferner mehrere Durchgangsöffnungen (16) für eine drahtgebundene Verbindung des Leistungsmoduls (12) mit einem Gerät außerhalb des dichten Gehäuses (14), wobei jede Durchgangsöffnung (16) durch die Wand eines entsprechenden Abschnitts hindurch gebildet ist, wobei eine Mehrzahl der Durchgangsöffnungen (16) durch die Wand (24) eines einzigen Endabschnitts (20) unter den mehreren Abschnitten (20, 22) gebildet ist, wobei der Endabschnitt (20) eine Länge (L1) aufweist, die kleiner ist als die Hälfe der Länge (L) des Gehäuses entlang der Längsrichtung (X).

2. Umwandlungsvorrichtung (10) nach Anspruch 1, wobei alle Durchgangsöffnungen (16) durch die Wand des Endabschnitts (20) hindurch gebildet sind.

3. Umwandlungsvorrichtung (10) nach einem beliebigen der vorhergehenden Ansprüche, wobei das dichte Gehäuse (14) ausschließlich zwei verschiedene Abschnitte (20, 22) aufweist, wobei der Endabschnitt (20) eine Länge (L1) aufweist, die kleiner ist als diejenige (L2) des anderen Abschnitts (22) entlang der Längsrichtung (X).

4. Umwandlungsvorrichtung (10) nach einem beliebigen der vorhergehenden Ansprüche, wobei der Endabschnitt (20) eine Länge (L1) aufweist, die kleiner als die 0,3-fache Länge (L) des Gehäuses entlang der Längsrichtung (X), vorzugsweise kleiner als das 0,2-fache der Länge (L) des Gehäuses, noch bevorzugter kleiner als die 0,1-fache Länge (L) des Gehäuses ist.

5. Umwandlungsvorrichtung (10) nach einem beliebigen der vorhergehenden Ansprüche, wobei der Endabschnitt (20) eine Kuppel (42) aufweist und die Durchgangsöffnung oder die Mehrzahl der Durchgangsöffnungen an der Kuppel (42) des Endabschnitts (20) angeordnet ist.

6. Umwandlungsvorrichtung (10) nach einem beliebigen der vorhergehenden Ansprüche, wobei der oder jeder Abschnitt (22), der sich von dem Endabschnitt (20) unterscheidet, und das Leistungsmodul (20) jeweils komplementäre Mittel (19, 26) zur Verschiebung entlang der Längsrichtung (X) aufweisen.

7. Vorrichtung (10) nach einem beliebigen der vorhergehenden Ansprüche, wobei die Dicke (E2) der Wand des oder jedes Abschnitts (22), der sich von dem Endabschnitt (20) unterscheidet, kleiner als diejenige (E1) der Wand des Endabschnitts (20), vorzugsweise um wenigstens 10% kleiner als diejenige (E1) der Wand des Endabschnitts (20), noch bevorzugter um wenigstens 30% kleiner als diejenige (E1) der Wand des Endabschnitts (20) ist.

8. Verfahren zur Herstellung einer Vorrichtung (10) zur Umwandlung elektrischer Energie für ein elektrisches Antriebssystem einer Unterwasserkompressions- und pumpstation, wobei die Vorrichtung (10) ein elektrisches Leistungsmodul (12), ein dichtes Gehäuse (14) zur Aufnahme des Leistungsmoduls (12), wobei das dichte Gehäuse (14) sich entlang einer Längsrichtung (X) erstreckt und wenigstens zwei aufeinanderfolgende Abschnitte (20, 22) entlang der Längsrichtung aufweist, die zwischen einer geschlossenen Stellung des Gehäuses (14), in der die Abschnitte (20, 22) aneinander fixiert sind, und einer offenen Stellung des Gehäuses (14) bewegbar sind, in der die Abschnitte (20, 22) sich im Abstand zueinander befinden, wobei jeder Abschnitt (20, 22) eine Wand (24, 25), und mehrere Durchgangsöffnungen (16) für eine drahtgebundene Verbindung des Leistungsmoduls (12) mit einem Gerät außerhalb der Umwandlungsvorrichtung (10) aufweist, wobei jede Durchgangsöffnung (16) durch die Wand eines entsprechenden Abschnitts hindurch gebildet ist,
wobei das Verfahren die folgenden Schritte aufweist:
- den Funktionstest des Leistungsmoduls (12) in der offenen Stellung des Gehäuses (14), im Verlauf dessen das Leistungsmodul (12) über die oder jede drahtgebundene Verbindung mit dem Gerät außerhalb der Umwandlungsvorrichtung (10) verbunden wird, und
- das Schließen des dichten Gehäuses (14) durch Fixierung der Abschnitte (20, 22) aneinander,
wobei das Verfahren **dadurch gekennzeichnet ist, dass** mehrere drahtgebundene Verbindungen durch die mehreren Durchgangsöffnungen (16) hindurchtreten, wobei eine Mehrzahl der Durchgangsöffnungen (16) durch die Wand eines Endabschnitts (20) unter den mehreren Abschnitten gebildet wird, wobei der Endabschnitt (20) eine Länge (L1) aufweist, die kleiner ist als die Hälfte der Länge (L) des Gehäuses entlang der Längsrichtung (X), und dadurch, dass die drahtgebundenen Verbindungen während des Schließschritts in Stellung gehalten werden.

9. Verfahren nach Anspruch 8, wobei jede Durchgangsöffnung (16) durch die Wand des Endabschnitts (20) hindurch gebildet wird und wobei während des Schließschritts jede drahtgebundene Verbindung im Inneren des Endabschnitts (20) und in der entsprechenden Durchgangsöffnung (16) gehalten wird.

## Claims

1. Device (10) for converting electrical power for an electric drive system of a submarine compression and pumping station, of the type comprising:
- an electric power module (12),
- a sealed enclosure (14) housing the power module (12), the sealed enclosure (14) extending in a longitudinal direction (X), and comprising at least two portions (20, 22) which are successive in the longitudinal direction (X) and are movable between a position closing the enclosure (14) in which the portions (20, 22) are fixed to each other, and a position opening the enclosure (14) in which the portions (20, 22) are spaced apart from each other, each portion (20, 22) comprising a wall (24, 25),
**characterised in that** the device (10) also comprises a plurality of openings (16) for passage of a wired connection of the power module (12) to an apparatus outside the sealed enclosure (14), each passage opening (16) being made through the wall of a corresponding portion, a majority of passage openings (16) being made through the wall (24) of a single end portion (20) of the plurality of portions (20, 22), the end portion (20) having a length (L1) which is less than half the length (L) of the enclosure in the longitudinal direction (X).

2. Conversion device (10) according to claim 1, wherein all passage openings (16) are made through the wall of the end portion (20).

3. Conversion device (10) according to one of the preceding claims, wherein the sealed enclosure (14) comprises only two separate portions (20, 22), the end portion (20) having a length (L1) which is less than that (L2) of the other portion (22) in the longitudinal direction (X).

4. Conversion device (10) according to any of the preceding claims, wherein the end portion (20) has a length (L1) which is less than 0.3 times the length (L) of the enclosure in the longitudinal direction (X), preferably less than 0.2 times the length (L) of the enclosure, further preferably less than 0.1 times the length (L) of the enclosure.

5. Conversion device (10) according to any of the preceding claims, wherein the end portion (20) comprises a dome (42), and the passage opening or the majority of passage openings is arranged on the dome (42) of the end portion (20).

6. Conversion device (10) according to any of the preceding claims, wherein the or each portion (22) separate from the end portion (20), and the power module (12) each comprise complementary means (19, 26) for sliding in the longitudinal direction (X).

7. Conversion device (10) according to any of the preceding claims, wherein the thickness (E2) of the wall of the or each portion (22) separate from the end portion (20) is less than that (E1) of the wall of the end portion (20), preferably less by at least 10% than that (E1) of the wall of the end portion (20), further preferably less by at least 30% than that (E1) of the wall of the end portion (20).

8. Method for production of a device (10) for converting electrical power for an electric drive system of a submarine compression and pumping station, the device (10) comprising an electric power module (12), a sealed enclosure (14) housing the power module (12), the sealed enclosure (14) extending in a longitudinal direction (X) and comprising at least two portions (20, 22) which are successive in the longitudinal direction (X) and are movable between a position closing the enclosure (14) in which the portions (20, 22) are fixed to each other, and a position opening the enclosure (14) in which the portions (20, 22) are spaced apart from each other, each portion (20, 22) comprising a wall (24, 25), and a plurality of openings (16) for passage of a wired connection of the power module (12) to an apparatus outside the conversion device (10), each passage opening (16) being made through the wall of a corresponding portion,
the method comprising the following steps:
- test of the function of the power module (12) in the position opening the enclosure (14), during which the power module (12) is connected via the or each wired connection to the apparatus outside the conversion device (10), and
- closure of the sealed enclosure (14) by fixing the portions (20, 22) to each other, the method being **characterised in that** a plurality of wired connections passes through the plurality of passage openings (16), a majority of the passage openings (16) being made through the wall of an end portion (20) of the plurality of portions, the end portion (20) having a length (L1) which is less than half the length (L) of the enclosure in the longitudinal direction (X), and **in that** the wired connections are held in position during the closing step.

9. Method according to claim 8, wherein each passage opening (16) is made through the wall of the end portion (20), and wherein during the closing step, each wired connection is held in position inside the end portion (20) and in the corresponding passage opening (16).
